# EUROPEAN PATENT APPLICATION

(11) **EP 4 685 822 A1**
(43) Date of publication of application: **28.01.2026**
(21) Application number: 25191024.6
(22) Date of filing: 22.07.2025
(51) Int. Cl.: H01C 7/102, C09D 11/02, C23C 26/00, H01B 1/22, H01G 4/008, H05K 3/02

(54) **HIGH-TEMPERATURE NI-BARRIER SINTERING PASTE**

(30) Priority: 22.07.2024 US 202463673833 P
(71) Applicant: Dongguan Littelfuse Electronics Company Limited, Dongguan, Guangdong 523925 (CN)
(72) Inventor: Talebinezhad, Hossein, Dongguan City, 523925 (CN); Chen, Jianhua, Dongguan City, 523925 (CN); Shenoy, Arjuna, Dongguan City, 523925 (CN); Yan, Jian, Dongguan City, 523925 (CN)
(74) Representative: Arnold & Siedsma

(57) **Abstract**

Disclosed herein is a novel enhanced silver-based paste using an alloying method to increase the melting temperature of the paste particles. In various embodiments, silver-coated Nickel particles, silver-coated silica particles or glass frits may be added to the silver paste in various concentrations to form an enhanced paste that performs when sintered at temperatures in excess of the melting temperature of the silver particles.

## Description

### Cross-Reference to Corresponding Applications

The present application claims the benefit of priority under 35 U.S.C. §119 to U.S. Provisional Application Serial No. 63/673,833, titled "HIGH-TEMPERATURE NI-BARRIER SINTERING PASTE" and filed July 22, 2024, the disclosure of which is incorporated herein by reference in its entirety.

### Background

Silver paste, known for its exceptional electrical conductivity, thermal stability, and adhesive properties, is a material used in the electronics industry. Many manufacturers utilize silver paste as an electrode in electronic components like fuses, varistors, and more. It can also be applied to PCBs to create conductive pathways, connections, and contacts due to its strong adhesion and conductivity. Typical silver paste is composed of silver particles sized in the nanometer to micrometer range, but typically less than 10 micrometers in diameter. The silver particles are distributed in a binder material, for example, a polymer.

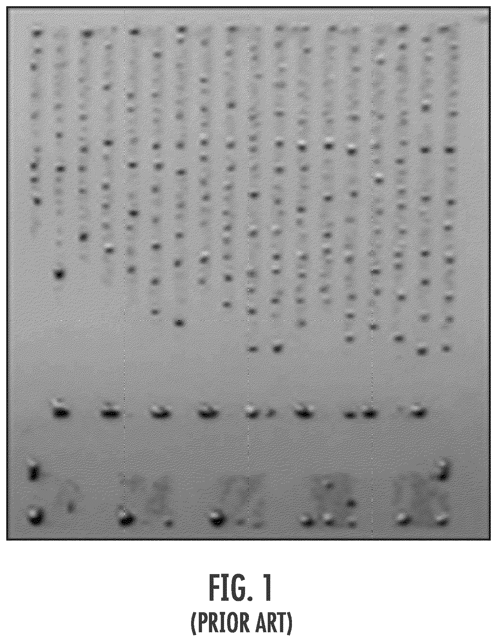

One important feature of silver paste compared to alternative pastes is its ability to perform reliably across a broad spectrum of temperatures, all while displaying a strong affinity for substrate adhesion. However, the usability of silver paste is constrained when dealing with operations requiring temperatures in excess of ~950°C, due to the melting point of silver. For example, when dealing with materials requiring sintering above 950°C, the utility of silver paste is restricted. In a specific example, a multi-layer varistor may use zinc oxide as a substrate, which must be sintered at temperatures exceeding 1000°C. The use of pure silver paste at these temperatures is not feasible. FIG. 1 shows an example of the results of sintering pure silver paste at temperatures exceeding the melting point of silver.

Therefore, it should be desirable to be able to provide a modified silver paste that allows sintering at temperatures above the melting point of silver (i.e., 968.1°C).

### Summary of the Invention

This Summary is provided to introduce a selection of concepts in a simplified form that are further described below in the Detailed Description. This Summary is not intended to identify key features or essential features of the claimed subject matter, nor is it intended as an aid in determining the scope of the claimed subject matter.

Disclosed herein is a novel silver paste using an interdiffusion method to increase the melting temperature of the paste particles. In one embodiment, metals, such as Nickel, that have a high melting temperature, can be used for alloying to the silver particles to increase the melting point of the silver paste. In a second embodiment, additives such as glass frits or silver-coated fused silica may be used to create a protective layer disposed between the substrate and the silver paste to prevent diffusion of the silver onto the substrate.

In a first illustrative example, a conductive paste comprises a binder, silver particles dispersed in the binder, and metallic particles dispersed in the binder, the metallic particles having a melting temperature higher than the melting temperature of the silver particles.

The metallic particles may comprise nickel particles coated with silver, and preferably the nickel particles comprise between 10%-50% of the total number of particles in the binder. The silver particles may comprise between 50% - 90% of the total number of particles in the binder. The diameter of the silver and metallic particles may be less than 10 microns. The binder may be a polymer. The paste may comprise additive particles disbursed in the conductive paste, the additive particles selected from a group consisting of silver-coated silica and glass frits, and preferably the glass frits comprise silicon oxide having a melting point exceeding the melting point of the silver particles.

In a second illustrative example, an electrode is provided. The electrode comprises a substrate and a conductive paste according to the first illustrative example, wherein the conductive paste is disposed on the substrate forming electrically conductive pathways.

The conductive paste may be a sintered alloy paste comprising silver particles and nickel particles coated with silver, each of the silver particles and the nickel particles coated with silver disposed within the binder.

In a third illustrative example, an electrode comprises a substrate and a sintered alloy paste comprising silver particles and nickel particles coated with silver, each of the silver particles and the nickel particles coated with silver disposed within a binder wherein the alloy is disposed on the substrate forming electrically conductive pathways.

In the electrode of the second or third illustrative examples, the paste, such as the sintered alloy paste, may be disposed on the substrate forming electrically conductive contacts, the contacts connected to the electrically conductive pathways.

In the electrode of the second or third illustrative examples, the nickel particles comprise between 10%-50% of the total number of particles in the binder.

In the electrode of the second or third illustrative examples, the diameter of the nickel and silver particles may be approximately 10 microns.

In the electrode of the second or third illustrative examples, the binder may be a polymer.

In the electrode of the second or third illustrative examples, the sintered allow paste may be disposed between zinc oxide layers.

In the electrode of the second or third illustrative examples, additive particles may be disbursed in the paste, such as the sintered alloy paste, the additive particles selected from a group consisting of silver-coated silica and glass frits having a melting point exceeding the melting point of the silver particles.

### Brief Description of the Drawings

By way of example, specific exemplary embodiments of the disclosed systems and methods will now be described, with reference to the accompanying drawings, in which:
FIG. 1 shows prior art results of sintering pure silver paste on a substrate at temperatures exceeding 1000°C.
FIG. 2 is a schematic representation of the enhanced paste in accordance with a first embodiment of the invention, showing a mixture of Silver and Nickel particles dispersed in a binder.
FIG. 3A shows the enhanced paste of the first embodiment distributed on a substrate to form conductive pathways and contacts. FIG. 3B is a post-sintering view showing the formed conductive pathways and contacts.
FIGS. 4(A-C) shows the enhanced paste of the first embodiment before sintering, after sintering at 960°C and after sintering at 1000°C, respectively.
FIG. 5 is a schematic representation of the enhanced paste in accordance with a second embodiment of the invention, showing a mixture of silver particles and additive particles dispersed in a binder.
FIG. 6A shows the enhanced paste of the second embodiment distributed on a substrate to form conductive pathways and contacts. FIG. 6B is a post-sintering view showing the formed conductive pathways and contacts.
FIG. 7A-7B show before and afterimages of a printed line of silver paste, one without Nickel particles and one mixed with silver-coated Nickel particles.
FIG. 8 is a graph showing the partial phase diagram between Nickel and silver.

### Detailed Description

Disclosed herein is a novel material comprising a silver paste having additives that will increase the tolerance of the material to the high temperatures typically used in the sintering of certain materials, for example, zinc oxide, which requires sintering at temperature exceeding 1000°C.

In a first embodiment of the invention, nickel particles or silver-coated nickel particles are mixed into the binder of the silver paste to form an enhanced paste. At temperatures around 900°C, the interdiffusion between the silver and nickel particles begins to create an intermix structure. The nickel is between the molten silver and the substrate (e.g., ZnO), and acts as a barrier to prevent the molten silver from directly contacting and potentially reacting with the substrate. The higher melting point and solid state of nickel at this temperature make it a good candidate to serve as a diffusion barrier. However, even with nickel serving as a barrier, some diffusion of silver through the nickel could occur and, depending on the thickness and integrity of the nickel layer, some silver might eventually reach the substrate. However, the presence of nickel significantly slows or limits this interaction.

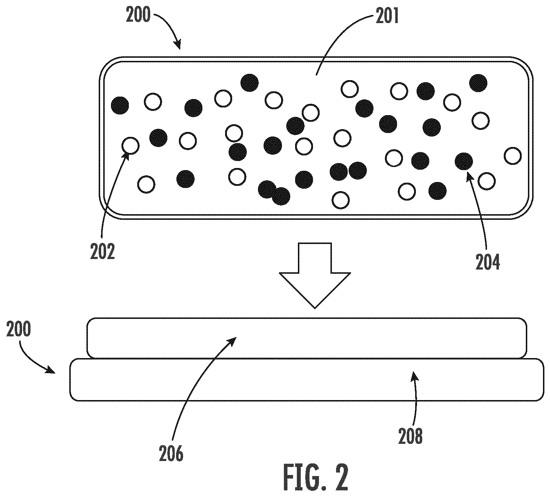

FIG. 2 is a schematic diagram showing the enhanced paste 200 formed in this embodiment of the invention. Both silver particles 204 and nickel particles 202 are dispersed in the binder 201. Preferably, the nickel particles 202 are silver coated to promote better distribution and binding with the silver particles 204. In preferred embodiments, the nickel particles 202 comprise between 10% and 50% of the total number of particles, with the remaining particles being silver particles. Preferably, the nickel particles and the silver particles will be of approximately the same diameter, which is preferably less than ~10 micrometers.

In variations of the first embodiment, other metals having melting points higher than silver may be used in place of nickel. Additionally, multiple different metals may be used in any ratio.

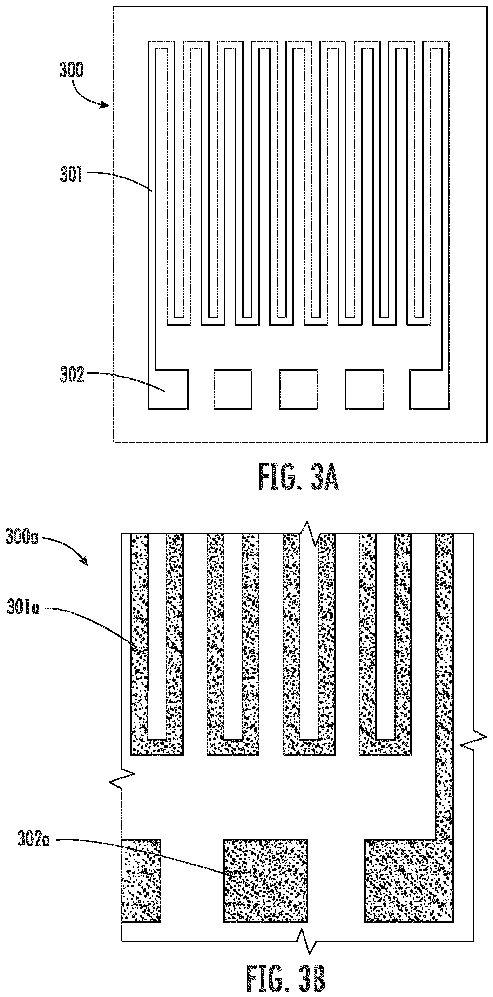

When sintered, the enhanced paste 200 forms a layer of alloy 206 on substrate 208, without the diffusion seen in FIG. 1. **FIG. 3A** shows the enhanced paste 200 in a layout 300 forming conductive pathways 301 and contacts 302 on a substrate, prior to sintering, while FIG. 3B shows a post-sintering view of the layout 300a forming conductive pathways 301a and contacts 302a, without the diffusion shown in FIG. 1.

In a second embodiment of the invention, additive particles are disbursed into the silver paste to form an enhanced paste. In variations of the second embodiment, the additive particles may comprise, for example, glass frits or silver-coated silica of a combination thereof. The glass frits may comprise silicon oxide having a melting point exceeding the melting point of silver and preferably in excess of 1000°C. The silver-coated silica is capable of absorbing some of the heat present in high-temperature sintering to raise the overall tolerance of the enhanced paste to high temperatures. In a variation of the second embodiment, both glass frits and silver-coated silica particles may be used together in any ratio.

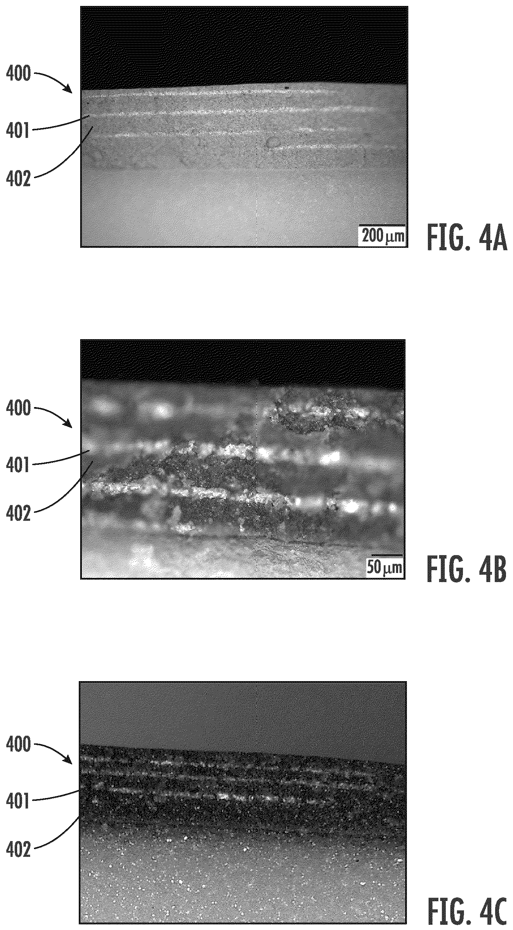

**FIGS. 4A-4C** show the multilayers of modified silver paste 400 with silver-coated Nickel particles 401 sandwiched between zinc oxide (ZnO) layers 402. The ZnO layers may be casted on the substrate. **FIG. 4A** shows the enhanced paste of the first embodiment after drying, but before sintering. FIG. 4B shows the paste after sintering at 960°C and FIG. 4C shows the paste after sintering at 1000°C. As can be observed, there is no delamination or discontinuity in the layers of printed paste.

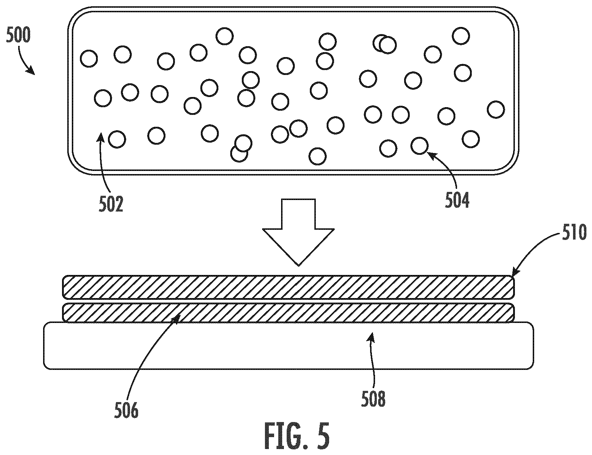

FIG. 5 is a schematic diagram showing the enhanced paste formed in the second embodiment of the invention. Both silver particles 504 and the additive particle 502 are dispersed in the binder 500. As with the first embodiment, the additive particles preferably comprise between 10% and 50% of the total particles present in the enhanced paste, with the remaining particles being silver particles. Preferably, the additive particles and the silver particles will be of approximately the same diameter, preferably less than ~10 micrometers.

When sintered, the enhanced paste forms a protective layer of alloy 506 on substrate 508, without the diffusion seen in FIG. 1. A layer of silver particles 510 forms above protective layer 506.

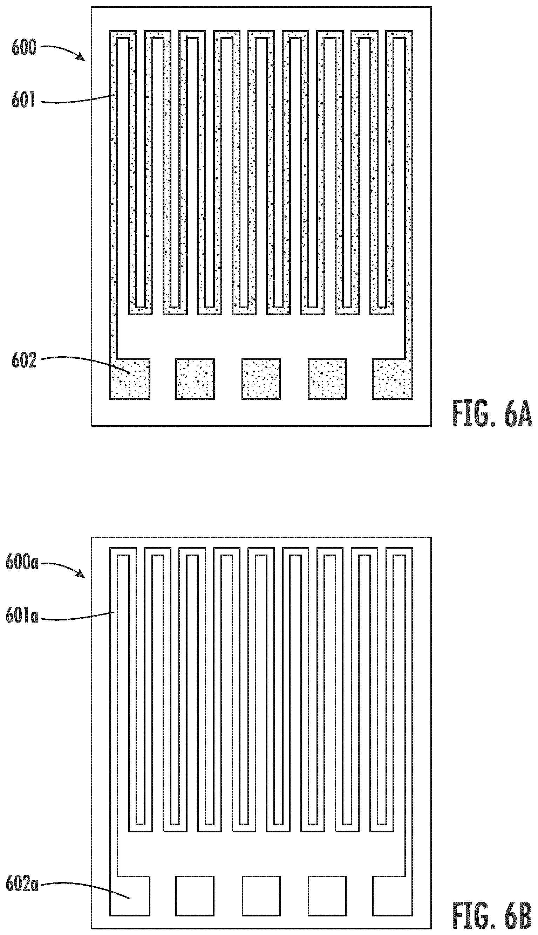

FIG. 6A shows the enhanced paste in a layout 600 forming conductive pathways 601 and contacts 602 on a substrate, prior to sintering, while FIG. 6B shows a post-sintering view, without the diffusion shown in FIG. 1.

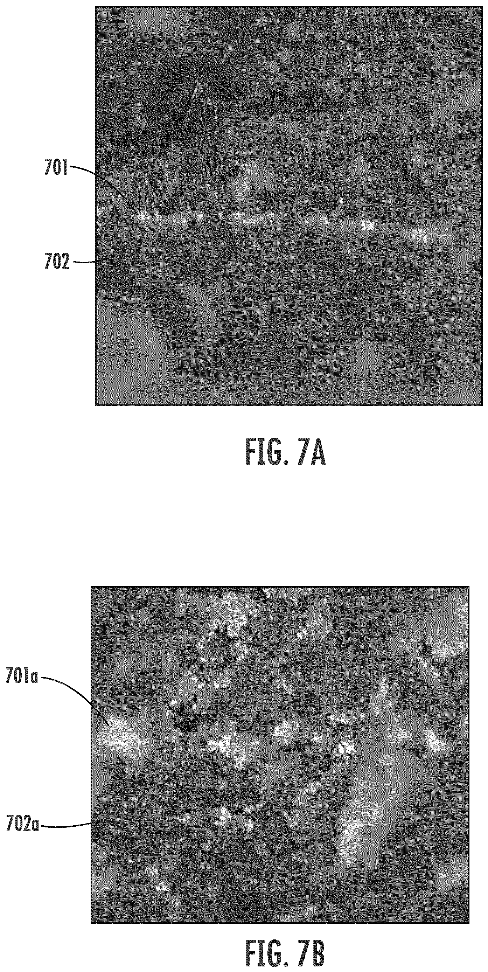

FIG. 7A shows a layer of pure silver paste 701 sintered at 960°C. In this figure, the substrate is ZnO 702 which is cast both on top of and below the printed silver paste. As can be seen there are discontinuities in the line of pure silver paste and the line of silver paste is fairly narrow. FIG. 7B shows a layer of modified silver paste with silver-coated Nickel particles 701a, which was also sintered at 960°C. As with FIG. 7A, the printed paste layer is sandwiched between cast layers of ZnO 702a. In contrast to FIG. 7A, FIG. 7B shows a continuous thick layer of printed silver paste after sintering.

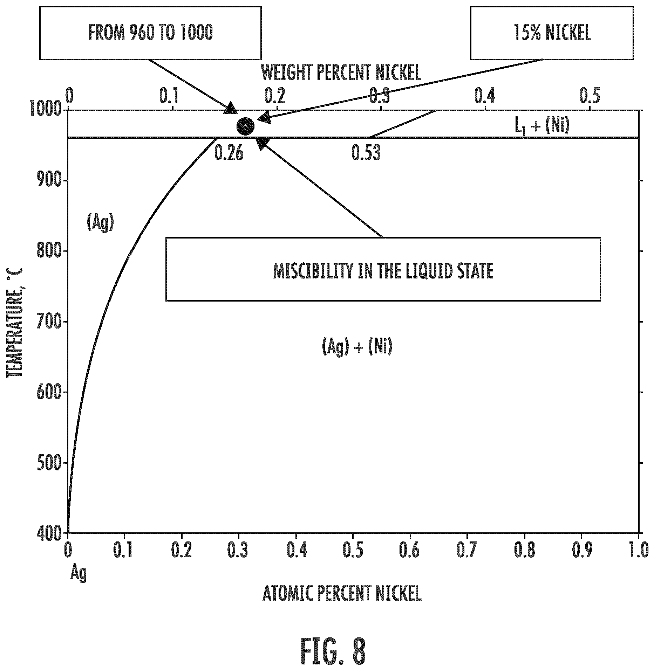

FIG. 8 is a graph showing the partial phase diagram between Nickel and silver, which presents the intermixing condition between the atoms of these two elements above the solidus temperature of 960°C. The graph shows up to a 30 % weight percent of Nickel can be completely mixed with silver.

The advantages of both embodiments of the invention are clearly seen. The enhanced paste enables the utilization of silver paste for sintering at temperatures exceeding the melting point of silver. A high level of compatibility is therefore established with substrates requiring sintering at elevated temperatures. Additionally, the adhesion of the enhanced paste to the substrate is improved compared to the silver paste.

As would be realized by one of skill in the art, many variations in the material discussed herein fall within the intended scope of the invention. For example, different metals in the first embodiment and different materials in the second embodiment, having melting points in excess of the melting point of silver may be used without deviating from the intended scope of the invention. Accordingly, the exemplary embodiments disclosed herein are not to be taken as limitations on the invention but as an illustration thereof. The scope of the invention is defined by the claims which follow.

## Claims

1. A conductive paste comprising:
a binder;
silver particles dispersed in the binder; and
metallic particles dispersed in the binder, the metallic particles having a melting temperature higher than the melting temperature of the silver particles.

2. The conductive paste of claim 1, wherein the metallic particles comprise nickel particles coated with silver.

3. The conductive paste of claim 2, wherein the nickel particles comprise between 10%-50% of the total number of particles in the binder.

4. The conductive paste of any one of claims 1-3, wherein the silver particles comprise between 50% - 90% of the total number of particles in the binder.

5. The conductive paste of any one of claims 1-4, wherein the diameter of the silver and metallic particles will be less than 10 microns.

6. The conductive paste of any one of claims 1-5, wherein the binder is a polymer.

7. The conductive paste of any one of claims 1-6, further comprising additive particles disbursed in the conductive paste, the additive particles selected from a group consisting of silver-coated silica and glass frits.

8. The conductive paste of claim 7, wherein the glass frits comprise silicon oxide having a melting point exceeding the melting point of the silver particles.

9. An electrode comprising:
a substrate; and
a sintered alloy paste comprising silver particles and nickel particles coated with silver, each of the silver particles and the nickel particles coated with silver disposed within a binder wherein the alloy is disposed on the substrate forming electrically conductive pathways.

10. The electrode of claim 9, wherein the sintered alloy paste is disposed on the substrate forming electrically conductive contacts, the contacts connected to the electrically conductive pathways.

11. The electrode of claim 9 or 10, wherein the nickel particles comprise between 10%-50% of the total number of particles in the binder.

12. The electrode of any one of claims 9-11, wherein the diameter of the nickel and silver particles will be approximately 10 microns.

13. The electrode of any one of claims 9-12, wherein the binder is a polymer.

14. The electrode of any one of claims 9-13, further wherein the sintered allow paste is disposed between zinc oxide layers.

15. The electrode of any one of claims 9-14, further comprising additive particles disbursed in the sintered alloy paste, the additive particles selected from a group consisting of silver-coated silica and glass frits having a melting point exceeding the melting point of the silver particles.
